# EUROPÄISCHE PATENTSCHRIFT

(11) **EP 2 080 424 B1**
(45) Veröffentlichungstag und Bekanntmachung des Hinweises auf die Patenterteilung: **06.07.2011**
(21) Anmeldenummer: 07818910.7
(22) Anmeldetag: 11.10.2007
(51) Int. Cl.: H05H 1/46, H01J 37/32

(54) **VORRICHTUNG UND VERFAHREN ZUR ERZEUGUNG VON MIKROWELLENPLASMEN HOHER PLASMADICHTE**
DEVICE AND METHOD FOR PRODUCING MICROWAVE PLASMA WITH A HIGH PLASMA DENSITY
DISPOSITIF ET PROCEDE POUR PRODUIRE DES PLASMAS MICRO-ONDES DE HAUTE DENSITE

(30) Priorität: 16.10.2006 DE 102006048814
(43) Veröffentlichungstag der Anmeldung: 22.07.2009
(73) Patentinhaber: Iplas Innovative Plasma Systems Gmbh, 53842 Troisdorf (DE)
(72) Erfinder: SPITZL, Ralf, 53842 Troisdorf (DE)
(74) Vertreter: Flaccus, Rolf-Dieter
(86) Internationale Anmeldenummer: PCT/EP2007/008839
(87) Internationale Veröffentlichungsnummer: WO 2008/046552

(56) Entgegenhaltungen:
- US-A1- 2003 141 182
- US-A1- 2006 156 983
- US-B1- 6 543 380

## Beschreibung

Die Erfindung betrifft eine Vorrichtung zur Erzeugung von Mikrowellenplasmen hoher Plasmadichte, welche mindestens eine Mikrowelleneinspeisung aufweist, die von mindestens einem dielektrischen Rohr umgeben ist. Desweiteren wird ein Verfahren zur Erzeugung von Mikrowellenplasmen hoher Plasmadichte durch Verwendung dieser Vorrichtung beschrieben.

Vorrichtungen zur Erzeugung von Mikrowellenplasmen werden bei der Plasmabehandlung von Werkstücken und Gasen eingesetzt. Die Plasmabehandlung dient z. B. der Beschichtung, Reinigung, Modifizierung und Ätzung von Werkstücken, zur Behandlung von medizinischen Implantaten, zur Textilbehandlung, zur Sterilisation, zur Lichterzeugung, bevorzugt im Spektralbereich Infrarot bis Ultraviolett, zur Umsetzung von Gasen oder zur Gassynthese sowie in der Technik zur Abgasreinigung. Dabei wird das zu behandelnde Werkstück oder Gas in Kontakt mit dem Plasma oder der Mikrowellenstrahlung gebracht.

Die Geometrie der zu behandelnden Werkstücke reicht von flachen Substraten, Fasern und Bahnen bis zu Formteilen von beliebiger Gestalt.

Die wichtigsten Prozessgase sind Edelgase, fluor- und chlorhaltige Gase, Kohlenwasserstoffe, Furane, Dioxine, Schwefelwasserstoffe, Sauerstoff, Wasserstoff, Stickstoff, Tetrafluormethan, Schwefelhexafluorid, Luft, Wasser und deren Mischungen. Bei der Abgasreinigung durch mikrowelleninduziertes Plasma besteht das Prozessgas aus Abgasen aller Art insbesondere Kohlenmonoxid, Kohlenwasserstoffe, Stickoxide, Aldehyde und Schwefeloxide. Diese Gase können jedoch ohne weiteres auch als Prozessgase für andere Anwendungen verwendet werden.

Vorrichtungen, die Mikrowellenplasmen erzeugen, sind in den Dokumenten WO 98/59359 A1, DE 198 480 22 A1 und DE 195 032 05 C1 beschrieben worden.

Den oben angeführten Dokumenten ist gemein, dass sie eine Mikrowellenantenne im Inneren eines dielektrischen Rohres beschreiben. Werden im Inneren eines solchen Rohres Mikrowellen erzeugt, bilden sich entlang dessen Außenseite Oberflächenwwellen aus. Durch diese Oberflächenwellen wird in einem Prozessgas, welches unter niedrigem Druck steht, ein linear gestrecktes Plasma erzeugt. Typische niedere Drücke sind dabei 0,1 mbar - 10 mbar. Das im Inneren des dielektrischen Rohres liegende Volumen ist typischerweise auf Umgebungsdruck (im Allgemeinen Normaldruck; ca. 1013 mbar). Bei einigen Ausführungsformen wird zur Kühlung des dielektrischen Rohres ein Kühlgasstrom benutzt, der das Rohr durchströmt.

Für die Zuleitung der Mikrowellen werden unter anderem Hohlleiter und Koaxialleiter, als Koppelstellen in der Wand der Plasmakammer werden unter anderem Antennen und Schlitze verwendet. Solche Zuleitungen für Mikrowellen und Koppelstellen werden zum Beispiel in DE 423 59 14 und WO 98/59359 A1 beschrieben.

Die zur Erzeugung des Plasmas verwendeten Mikrowellenfrequenzen liegen vorzugsweise im Bereich von 800 MHz bis 2,5 GHz, besonders bevorzugt in den Bereichen 800 MHz bis 950 MHz und 2,0 - 2,5 GHz, jedoch kann die Mikrowellenfrequenz im gesamten Bereich von 10 MHz bis einigen 100 GHz liegen.

DE 198 480 22 A1 und DE 195 032 05 C1 beschreiben Vorrichtungen zur Erzeugung von Plasma in einer Vakuumkammer mit Hilfe von elektromagnetischen Wechselfeldern, mit einem Leiter, der innerhalb eines Rohres aus isolierendem Werkstoff in die Vakuumkammer hineinragt, wobei das Isolierrohr an beiden Enden durch Wände der Vakuumkammer gehalten und gegenüber den Wänden an seiner Außenfläche abgedichtet ist. Die Enden des Leiters sind an einen Generator zur Erzeugung der elektromagnetischen Wechselfelder angeschlossen.

Mit einer Vorrichtung zur Erzeugung von homogenen Mikrowellenplasmen gemäß WO 98/59359 A1 lassen sich aufgrund der gleichmäßigen Einkopplung der Mikrowellen besonders homogene Plasmen auch bei höheren Prozessdrücken über große Längen erzeugen.

Die Einsatzmöglichkeiten der oben genannten Plasmaquellen werden durch eine hohe Energieabgabe des Plasmas auf das dielektrische Rohr eingeschränkt. Durch diese Energieabgabe kann es zu einer übermäßigen Erwärmung des Rohres und letztendlich zu einer Zerstörung desselben kommen. Daher werden diese Quellen typischerweise mit Mikrowellenleistungen von ca. 1 - 2 kW bei entsprechend niedrigem Druck (ca. 0,1 - 0,5 mbar) betrieben. Die Prozessdrücke können zwar auch 1 mbar - 100 mbar betragen, jedoch nur unter bestimmten Bedingungen und entsprechend niedrigerer Leistung, um das Rohr nicht zu zerstören.

Mit den oben genannten Vorrichtungen lassen sich typische Plasmalängen von 0,5 - 1,5 m erreichen. Mit Plasmen aus nahezu 100% Argon lassen sich zwar auch größere Längen erzielen, jedoch sind solche Plasmen technisch wenig relevant.

Ein weiteres Problem bei solchen Plasmaquellen liegt in der Prozessgasführung insbesondere bei höheren Prozessgasdrücken (größer als 1 mbar). Die Ursache hierfür liegt darin begründet, dass die Plasmadichte in zunehmender radialer Entfernung vom dielektrischen Rohr stark abnimmt. Dies erschwert die Zuführung von neuem Prozessgas zu den Bereichen hoher Ladungsträgerdichten. Desweiteren steigt bei höheren Prozessdrücken die auf das dielektrische Rohr abgegebene Wärmeleitung.

Höhere Prozessgasdrücke sind jedoch bevorzugt, da sie häufig zu deutlichen Steigerungen der Prozessgeschwindigkeiten, um das 10 bis 100-fache, führen.

Aufgabe der vorliegenden Erfindung ist es, die oben genannten Nachteile zu überwinden und so eine Steigerung der Plasmakonzentration und des Prozessgasdrucks zu erhalten.

Dies wird erfindungsgemäß durch eine Vorrichtung zur Erzeugung von Mikrowellenplasmen nach Anspruch 1 erreicht. Diese Vorrichtung weist mindestens eine Mikrowelleneinspeisung auf, die von einem inneren dielektrischen Rohr umgeben ist. Dieses innere dielektrische Rohr ist wiederum von mindestens einem äußeren dielektrischen Rohr umgeben. Dadurch wird ein Raum gebildet, der zur Aufnahme und Durchleitung eines Fluids geeignet ist.

Die Vorrichtung ermöglicht in vorteilhafter Weise die Durchleitung eines Fluids durch die oben beschriebene Doppelrohranordnung, welches zur Kühlung oder der Zuführung zum Prozessgas verwendet werden kann.

Geeignete Mikrowelleneinspeisungen sind dem Fachmann bekannt. Im Allgemeinen besteht eine Mikrowelleneinspeisung aus einer Struktur, die Mikrowellen in den Raum abstrahlen kann. Strukturen, die Mikrowellen abstrahlen, sind dem Fachmann bekannt und können durch alle bekannten Mikrowellenantennen und Resonatoren mit Koppelstellen zum Einkoppeln der Mikrowellenstrahlung in einen Raum realisiert werden. Bevorzugt für die beschriebene Vorrichtung sind Hohlraumresonatoren, Stabantennen, Schlitzantennen, Helixantennen und omnidirektionale Antennen. Besonders bevorzugt sind Koaxialresonatoren.

Die Mikrowelleneinspeisung ist im Betrieb über Mikrowellenzuleitungen (Hohlleiter oder Koaxialleiter) mit einem Mikrowellengenerator (z.B. Klystron oder Magnetron) verbunden. Zur Steuerung der Eigenschaften der Mikrowellen und zum Schutz der Elemente können noch Zirkulatoren, Isolatoren, Tuningelemente (z.B. Dreistifttuner oder E/H Tuner) sowie Modenkonverter (z.B. Rechteck- auf Koaxialleiter) in die Mikrowellenzuführung eingebracht werden.

Die dielektrischen Rohre sind vorzugsweise langgestreckt. Dies bedeutet hier, dass das Verhältnis Rohrdurchmesser Rohrlänge zwischen 1:1 und 1:1000 liegt und vorzugsweise 1:10 bis 1:100 beträgt. Dabei können die beiden Rohre gleichlang sein oder eine unterschiedliche Länge aufweisen. Ferner sind die Rohre vorzugsweise gerade, können jedoch auch eine gebogene Form oder Ecken entlang ihrer Längsachse haben.

Die Querschnittsfläche der Rohre ist vorzugsweise kreisrund, jedoch sind generell beliebige Flächenformen möglich. Beispiele für andere Flächenformen sind Ellipsen und Polygone.

Die langgestreckte Form der Rohre bedingt ein langgestrecktes Plasma. Langgestreckte Plasmen haben den Vorteil, dass durch Bewegung der Plasmavorrichtung relativ zu einem flächigen Werkstück große Flächen in kurzer Zeit behandelt werden können.

Die dielektrischen Rohre sollten bei der gegebenen Mikrowellenfrequenz einen geringen dielektrischen Verlustfaktor tan δ für die benutzte Mikrowellenlänge aufweisen. Geringe dielektrische Verlustfalctoren tan δ liegen in dem Bereich 10⁻² bis 10⁻⁷.

Geeignete dielektrische Materialien für die dielektrischen Rohre sind Metalloxide, Halbmetalloxide, Keramiken, Kunststoffe und Verbundmaterialien aus diesen Stoffen. Besonders bevorzugt sind dielektrische Rohre aus Quarzglas oder Aluminiumoxyd mit dielektrischen Verlustfaktoren tan δ im Bereich 10⁻³ bis 10⁻⁴. Dabei können die dielektrischen Rohre aus demselben Material oder unterschiedlichen Materialien bestehen.

Gemäß einer besonderen Ausführungsform sind die dielektrischen Rohre an den Stirnseiten mit Wänden verschlossen. Eine gas- oder vakuumdichte Verbindung zwischen den Rohren und den Wänden ist dabei vorteilhaft. Verbindungen zwischen zwei Werkstücken sind dem Fachmann bekannt und können zum Beispiel Klebe-, Schweiß-, Klemm- oder Schraubverbindungen sein. Die Dichtigkeit der Verbindung kann von gasdicht bis vakuumdicht reichen, wobei vakuumdicht, je nach Arbeitsumgebung, Dichtigkeit im Grobvakuum (300 - 1 hPa), Feinvakuum (1 - 10⁻³ hPa), Hochvakuum (10⁻³ - 10⁻⁷ hPa) oder Ultrahochvakuum (10⁻⁷ - 10⁻¹² hPa) bedeutet. Im Allgemeinen bedeutet vakuumdicht hier eine Dichtigkeit im Grob- oder Feinvakuum.

Die Wände können Durchlässe aufweisen, durch die ein Fluid geleitet werden kann. Dabei ist die Größe und Form der Durchlässe beliebig. Je nach Anwendung kann jede Wand mindestens einen Durchlass enthalten. Bei einer bevorzugten Ausführungsform befinden sich in dem Bereich, den die Stirnseite des inneren dielektrischen Rohres abdeckt, keine Durchlässe.

Das Fluid wird durch den Raum zwischen dem äußeren dielektrischen Rohr und dem inneren dielektrischen Rohr geleitet und über die Öffnungen in den Wänden an den Stirnseiten des dielektrischen Rohres zu- beziehungsweise abgeführt. Die Durchstömungsgeschwindigkeit und das Durchströmverhalten (laminar oder turbulent) des dielektrischen Fluids durch das dielektrische Rohr ist so zu wählen, dass das Fluid, besonders wenn es sich um eine Flüssigkeit handelt, einen guten Kontakt mit dem Rand des dielektrischen Rohres hat und es zusätzlich bei flüssigen Fluiden zu keiner Verdampfung der dielektrischen Flüssigkeit kommt. Die Regelung der Durchströmgeschwindigkeit und des Durchströmverhaltens mittels des Drucks und der Form und Größe der Durchlässe ist dem Fachmann bekannt.

Als dielektrisches Fluid kann sowohl ein Gas als auch eine dielektrische Flüssigkeit verwendet werden.

Jedoch ist eine Kühlung des dielektrischen Rohres durch ein Fluid nicht in einfacher Weise zu realisieren, da der Energieeintrag der Mikrowellen auf das Fluid dieses erwärmt. Durch jede zusätzliche Aufheizung des Fluids wird der Kühleffekt auf das dielektrische Rohr vermindert. Diese Verminderung der Kühlleistung kann bei hoher Mikrowellenabsorption des Fluids auch zu einer negativen Kühlleistung führen. Dies entspricht einer zusätzlichen Erwärmung des dielektrischen Rohres.

Um eine Aufheizung des Fluids durch die Mikrowellen möglichst gering zu halten, muss das Fluid bei der Wellenlänge der Mikrowellen einen niedrigen dielektrischen Verlustfaktor tan δ im Bereich 10⁻² bis 10⁻⁷ aufweisen. Hierdurch wird ein Mikrowellenleistungseintrag in das Fluid vermieden bzw. auf ein tolerierbares Maß reduziert.

Flüssige Fluide bieten aufgrund des größeren Wärmekoeffizienten eine größere Aufnahme der Wärmeleistung als gasförmige Fluide.

Eine solche dielektrische Flüssigkeit ist zum Beispiel ein isolierendes Öl mit einem niedrigen dielektrischen Verlustfaktor. Isolierende Öle sind zum Beispiel Mineralöle, Olefine (z.B. Polyalphaolefin) oder Silikonöle (z.B. Coolanol® oder Dimethylpolysiloxane). Bevorzugt als dielektrische Flüssigkeit ist Hexadimethylsiloxan.

Durch diese Fluid-Kühlung des äußeren dielektrischen Rohres ist es möglich, die Aufheizung des äußeren dielektrischen Rohres zu vermindern. Dadurch werden höhere Mikrowellenleistungen ermöglicht, die wiederum zu einer Steigerung der Konzentration des Plasmas an der Außenseite des äußeren dielektrischen Rohres führen. Desweiteren wird durch die Kühlung ein höherer Prozessdruck möglich als in ungekühlten Plasmaerzeugern.

Im Gegensatz zu einer Gaskühlung gemäß DE 195 032 05, bei der das Kühlgas Kontakt zu der Mikrowelleneinspeisung hat, wird in der hier beschriebenen Vorrichtung durch die Doppelrohranordnung der Kontakt zwischen Fluid und der Mikrowelleneinspeisung vermieden, und somit die Möglichkeit ausgeschlossen, dass das Fluid mit der Mikrowelleneinspeisung reagieren kann. Desweiteren wird durch diese Trennung von Fluid und Mikrowelleneinspeisung eine Wartung der Mikrowelleneinspeisung erheblich vereinfacht.

Bei einer bevorzugten Ausführungsform wird erfindungsgemäß das Material des äußeren dielektrischen Rohres durch ein poröses dielektrisches Material ersetzt. Geeignete poröse dielektrische Materialien sind Keramiken oder gesinterte Dielektrika, bevorzugt Aluminiumoxid. Es ist jedoch auch möglich, Rohrwandungen aus Quarzglas oder Metalloxiden mit kleinen Löchern zu versehen.

Bei dem Durchfluss eines Gases zwischen den dielektrischen Rohren entweicht nun ein Teil des Gases durch diese Poren. Da an der Oberfläche des äußeren dielektrischen Rohres die höchsten Mikrowellenfeldstärken herrschen, durchwandern die Gasmoleküle beim Durchgang durch das äußere dielektrische Rohr die Zone der höchsten Ionendichte.

Desweiteren besitzt das Gas nach dem Durchgang durch die Poren eine resultierende Bewegungsrichtung radial vom Rohr weg.

Wird zur Kühlung das gleiche Gas benutzt, das auch als Prozessgas verwendet wird, wird der Anteil der angeregten Teilchen durch die Passage des Prozessgases durch den Bereich größter Mikrowellenintensität gesteigert. Dadurch ist auf diese Weise ein effizienter Transport von angeregten Teilchen zum Werkstück gewährleistet. Dies steigert sowohl die Konzentration als auch den Fluss der angeregten Teilchen.

Eine solche Anordnung ist des Weiteren ebenfalls besonders gut geeignet, um reine Gaskonversionsprozesse wie Abgasreinigung oder Gassyntheseprozesse durchzuführen. Weitere Prozessgase lassen sich gegebenenfalls durch weitere poröse Rohre der Prozesskammer zuführen.

Durch die Porosität des äußeren dielektrischen Rohres und den Gasdruck wird der Fluss (Moleküle pro Fläche pro Zeit) des Prozessgases oder Prozessgasgemischs durch das äußere dielektrische Rohr geregelt.

Desweiteren müssen bei diesem Abgasreinigungsverfahren alle Gasmoleküle die Rohrwand und damit den Bereich höchster Ionendichte passieren. Dies stellt einen vorteil gegenüber gängigen Verfahren dar, bei denen sich die Brennkammer im Inneren eines Volumens befindet, und die Mikrowellen von außen eingestrahlt werden. Der Anteil des gereinigten Abgases ist bei einem gängigen Verfahren geringer als bei dem hier vorgestellten, da bei einem solchen gängigen Verfahren Teile des Gases, die sich in der Nähe der Wände des Volumens befinden, aufgrund der dort herrschenden niedrigen Feldstärken nicht ionisiert werden.

Als Prozessgas kann jedes bekannte Gas genutzt werden. Die wichtigsten Prozessgase sind Edelgase, fluor- und chlorhaltige Gase, Kohlenwasserstoffe, Furane, Dioxine, Schwefelwasserstoffe, Sauerstoff, Wasserstoff, Stickstoff, Tetrafluormethan, Schwefelhexafluorid, Luft, Wasser und deren Mischungen. Bei der Abgasreinigung durch mikrowelleninduziertes Plasma besteht das Prozessgas aus Abgasen aller Art insbesondere Kohlenmonoxid, Kohlenwasserstoffe, Stickoxide, Aldehyde und Schwefeloxide. Diese Gase können jedoch ohne weiteres auch als Prozessgase für andere Anwendungen verwendet werden.

Gemäß einer weiteren Ausführungsform kann ein weiteres dielektrisches Rohr innerhalb des äußeren dielektrischen Rohres eingebracht werden, das das innere dielektrische Rohr umgibt und ebenfalls an seinen Stirnseiten gas- oder vakuumdicht mit den Wänden verbunden ist. In dieser Ausführungsform wird der Raum zwischen dem äußeren dielektrischen Rohr und dem inneren dielektrischen Rohr in einen äußeren- und einen inneren Raum geteilt.

Wird nun das Prozessgas durch den äußeren Raum geleitet, und ein Fluid durch den inneren Raum geleitet, ist eine Kühlung des inneren dielektrischen Rohres und der Mikrowellenstruktur möglich. Dies wiederum ermöglicht eine höhere Prozessleistung. Das Fluid sollte dabei die Mikrowellen nicht absorbieren. Insbesondere bei der Verwendung einer Flüssigkeit als Fluid sollte die Flüssigkeit für die benutzte Mikrowellenlänge einen geringen dielektrischen Verlustfaktor tan δ im Bereich 10⁻² bis 10⁻⁷ aufweisen.

Um den Mikrowellenleistungsbedarf bei den oben aufgeführten Plasmaquellen weiter zu reduzieren, kann gemäß einer weiteren bevorzugten Ausführungsform eine metallische Ummantelung um das äußere dielektrische Rohr angebracht werden, welches dieses Rohr partiell abdeckt. Diese metallische Ummantelung wirkt dabei als Mikrowellenabschirmung und kann z.B. aus einem Metallrohr, einem gebogenen Metallblech, einer Metallfolie oder auch aus einer metallischen Schicht bestehen und aufgesteckt, aufgalvanisiert oder auf eine andere Weise aufgebracht sein. Solche metallischen Mikrowellenabschirmungen können den Windelbereich, in dem die Erzeugung des Plasmas stattfindet, beliebig begrenzen (z.B. auf 90°, 180° oder 270°) und so den Leistungsbedarf entsprechend reduzieren.

Insbesondere bei der Ausführungsform mit einer metallischen Ummantelung der Vorrichtungen zur Erzeugung von Mikrowellenplasmen ist es möglich, breite Werkstoffbahnen mit nur geringer verlustleistung mit einem Plasma zu behandeln. Durch die Ummantelung wird der Raumbereich der Vorrichtung, der dem Werkstück nicht zugewandt ist, abgeschirmt, und nur ein schmaler Plasmastreifen zwischen Werkstück und Vorrichtung über die gesamte Breite des Werkstückes erzeugt.

Alle oben beschriebenen Vorrichtungen zur Erzeugung von Plasmen bilden während des Betriebs an der Haubenseite des dielektrischen Rohres ein Plasma aus. Im Normalfall wird die Vorrichtung im Inneren eines Raumes (Plasmakammer) betrieben. Diese Plasmakamaner kann je nach Betriebsart verschiedene Formen und Öffnungen aufweisen und verschiedene Funktionen erfüllen. Zum Beispiel kann die Plasmakammer das zu bearbeitende Werkstück und das Prozessgas enthalten (direkter Plasmaprozess) oder Prozessgase und Öffnungen für den Plasmaaustritt aufweisen (remote-Plasmaprozess, Abgasreinigung).

Bei einem Verfahren zur Erzeugung Mikrowellenplasmen in einer oben beschriebenen Vorrichtung wird ein Fluid durch den Raum zwischen dem inneren dielektrischen Rohr und dem äußeren dielektrischen Rohr, vorzugsweise durch Durchlässe in den Wänden, geleitet. Das Fluid kann dabei ein Gas oder eine Flüssigkeit sein.

Der Druck des Fluids kann dabei größer, kleiner oder gleich dem Atmosphärendruck sein.

In einer vorteilhaften Ausführung wird ein gasförmiges Fluid, vorzugsweise ein Prozessgas, besonders bevorzugt ein Abgas, durch das poröse Rohr der oben beschriebenen Vorrichtung mit einem porösen äußernen Rohr geleitet und so einem Plasmaprozess zugeführt. Das Fluid hat dabei bevorzugt einen geringen dielektrischen Verlustfaktor tan δ im Bereich 10⁻² bis 10⁻⁷.

In einer weiteren vorteilhaften Ausführung fließt in der oben beschriebenen Vorrichtung, welche ein inneres mittleres und äußere dielektrische Rohr enthält, fließt in dem Raum zwischen dem äußeren dielektrischen Rohr und dem mittleren dielektrischen Rohr ein Gas, welches vorzugsweise ein Prozessgas ist, und in dem Raum zwischen dem inneren dielektrischen Rohr und dem mittleren dielektrischen Rohr ein Fluid; welches vorzugsweise einen geringen dielektrischen Verlustfaktor tan δ hat. Das äußere dielektrische Rohr weist dabei vorzugsweise eine poröse Wand auf.

Die Erfindung wird nachfolgend anhand der in den Zeichnungen schematisch dargestellten Ausführungsformen beispielhaft erläutert.
Figur 1 zeigt Schnittzeichnungen der oben beschriebenen Vorrichtung.
Figur 2 zeigt Schnittzeichnungen der oben beschriebenen Vorrichtung mit porösem äußerem dielektrischem Rohr.
Figur 3 zeigt Schnittzeichnungen der oben beschriebenen Vorrichtung mit einer zusätzlichen Kühlung.
Figur 4 zeigt eine Ausführungsform mit einer metallischen Ummantelung.
Figur 5 zeigt eine Schnittzeichnung der oben beschriebenen Vorrichtung eingebaut in einer Plasmakammer.
Figuren 6A und 6B zeigen eine mögliche Ausführungsform zur Behandlung großflächiger Werkstücke.

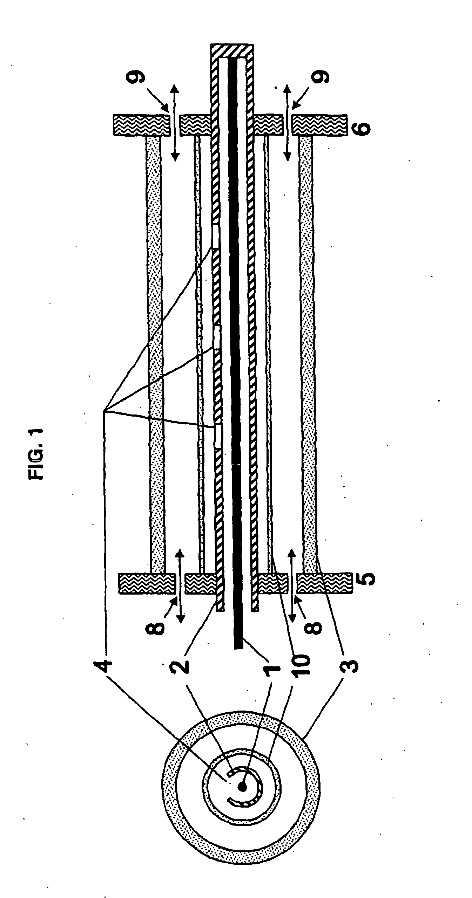

Figur 1 zeigt den Quer- und Längsschnitt einer Vorrichtung zur Erzeugung von Mikrowellenplasmen mit einer als Koaxialresonator ausgeführten Mikrowelleneinspeisung. Die Mikrowelleneinspeisung enthält einen Innenleiter (1), einen Außenleiter (2) und Koppelstellen (4). Die Mikrowelleneinspeisung ist von einem äußeren dielektrischen Rohr (3) umgeben, das den mikrowellenzuführenden Bereich von der Plasmakammer (nicht eingezeichnet) trennt, und auf dessen Außenseite sich das Plasma ausbildet. Das äußere dielektrische Rohr (3) ist mit den Wänden (5, 6) gas- oder vakuumdicht verbunden. Zwischen dem Koaxialgenerator und dem äußeren dielektrischen Rohr ist ein inneres dielektrisches Rohr (10) eingefügt, welches ebenfalls mit den Wänden (5, 6) gas- oder vakuumdicht verbunden ist, und mit dem äußeren dielektrischen Rohr (3) einen von der Mikrowelleneinspeisung abgetrennten Raum bildet, durch den ein Fluid fließen kann. Das Fluid kann über die Öffnungen (8) und (9) zu- bzw. abgeführt werden.

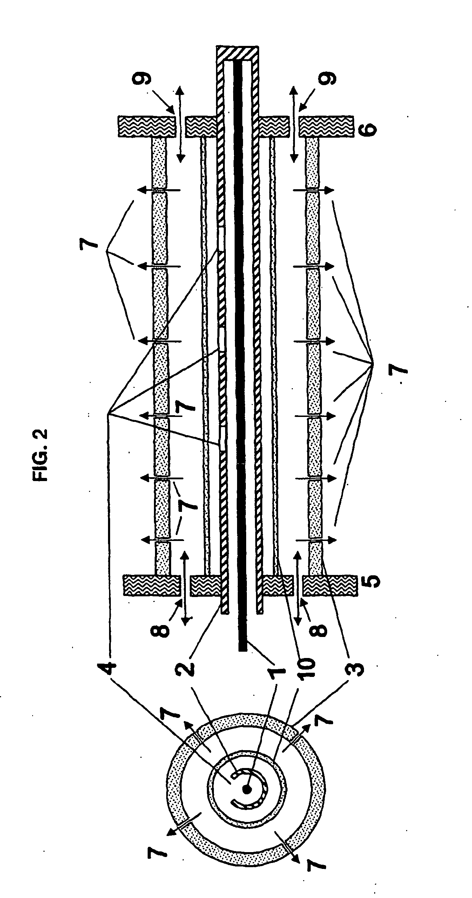

Figur 2 zeigt den Quer- und Längsschnitt einer Ausführungsform der in Figur 1 skizzierten Vorrichtung zur Erzeugung von Mikrowellenplasmen, bei der die Wand des äußeren dielektrischen Rohres (3) Poren (7) aufweist. Die Poren (7) sind in der Zeichnung zur besseren Darstellung stark vergrößert dargestellt. Durch diese Poren (7) kann Gas durch das äußere dielektrische Rohr in die Plasmakammer geführt werden. Dabei passiert es die Rohrwand des äußeren dielektrischen Rohres (3), an der die Feldstärke der Mikrowellen und damit die Ionisation des Plasmas am größten ist.

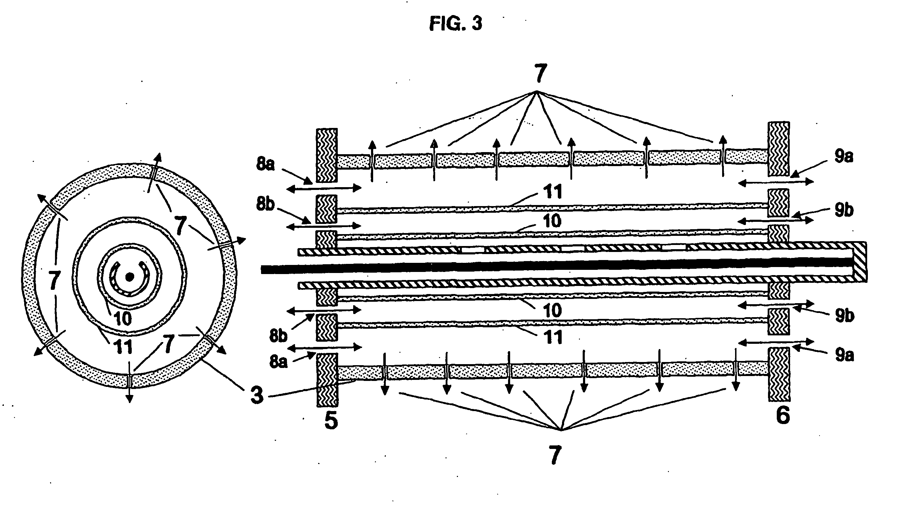

Figur 3 zeigt den Quer- und Längsschnitt einer Ausführungsform der in Figur 1 skizzierten Vorrichtung zur Erzeugung von Mikrowellenplasmen, bei der die Mikrowelleneinspeisung von drei ineinander liegenden Rohren umgeben ist. Diese Tripelrohranordnung umfasst ein inneres dielektrisches Rohr (10), welches von einem mittleren dielektrischen Rohr (11) umgeben ist, das wiederum von dem äußeren dielektrischen Rohr (3) umgeben ist. Alle drei dielektrischen Rohre sind mit den Wänden (5, 6) gas- oder vakuumdicht verbunden. Ein Prozessgas kann über die Öffnungen (8a) und (9a) zu- bzw.
abgeführt werden und durch Poren (7) im äußeren dielektrischen Rohr (3) austreten. Auch hier sind die Poren (7) in der Zeichnung zur besseren Darstellung stark vergrößert dargestellt. Ein Fluid zum Kühlen der Anordnung fließt durch den inneren Raum zwischen dem mittleren dielektrischen Rohr (11) und dem inneren dielektrischen Rohr (10) und kann über die Öffnungen (8b) und (9b) zu- bzw. abgeführt werden.

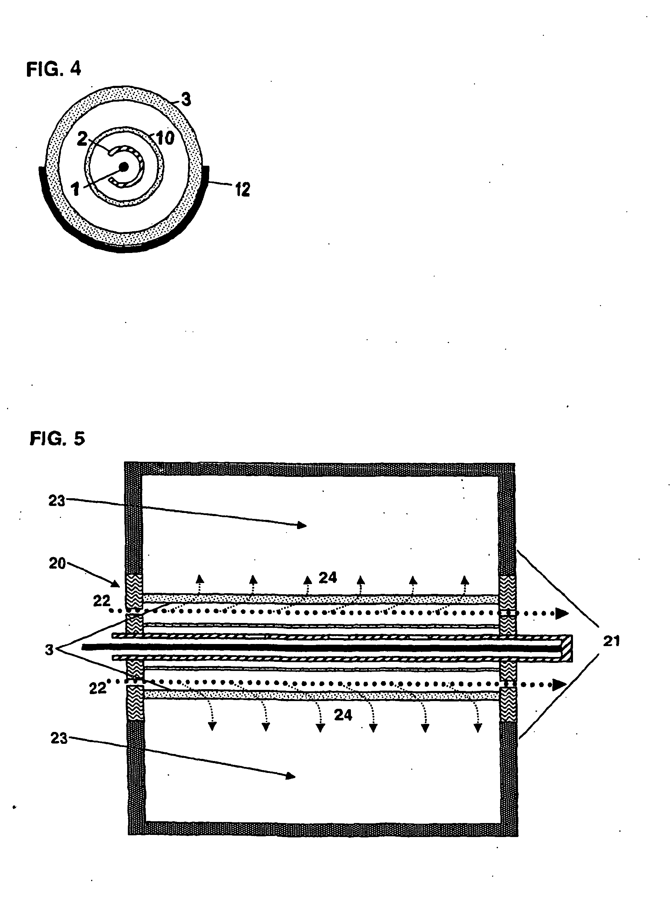

Figur 4 zeigt einen Querschnitt einer Ausführungsform der in Figur 1 dargestellten Vorrichtung, bei der das äußere dielektrische Rohr (3) von einer metallischen Ummantelung (12) umgeben ist. In dem in Figur 4 dargestellten Fall wird dabei von der metallischen Ummantelung der Winkelbereich, in dem die Erzeugung des Plasmas stattfindet, auf 180° begrenzt.

Figur 5 zeigt einen Längsschnitt einer Vorrichtung (20), wie sie durch Figur 1 beschrieben wird, im eingebauten Zustand in einer Plasmakammer (21). Die Kühlflüssigkeit (22) fließt in diesem Beispiel durch Durchlässe in den beiden Stirnseiten. In dem Raum (23) zwischen dem äußeren dielektrischen Rohr (3) und der Wand der Plasmakammer bildet sich im Betrieb das Plasma aus.

In einer bevorzugten Ausführungsform, in der das äußere dielektrische Rohr (3) eine poröse Rohrwand aufweist, wie in Figur 2 skizziert wurde, strömt das Kühlgas, welches gleichzeitig das Prozessgas ist, wie durch die Pfeile (24) angedeutet wird, durch die Rohrwand in den Raum (23) und bildet ein Plasma.

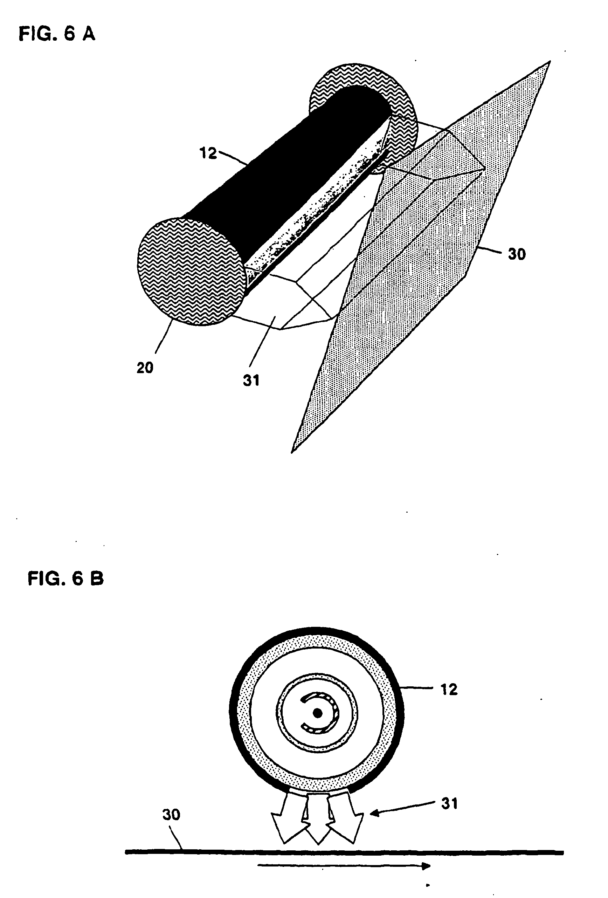

Figuren 6A und 6B zeigen in einer perspektivischen Darstellung und in einem Querschnitt eine Ausführungsform (20), bei der der größte Teil der Mantelfläche des äußeren dielektrischen Rohres von einer Metallummantelung (12) umschlossen ist, und ein Plasma (31), welches in der Zeichnung durch durchsichtige Pfeile angedeutet ist, nur in einem schmalen Bereich entstehen kann. Ein Werkstück (30), welches sich relativ zu der Vorrichtung bewegt, kann in diesem Bereich mit Plasma über eine große Fläche behandelt werden.

Alle Ausführungsformen werden von einer in den Zeichnungen nicht dargestellten Mikrowellenzufuhr, bestehend aus einem Mikrowellengenerator und ggf. zusätzlichen Elementen, gespeist. Diese Elemente können z.B. Zirkulatoren, Isolatoren, Tuningelemente (z.B. Dreistifttuner oder E/H Tuner) sowie Modenkonverter (z.B. Rechteck- auf Koaxialleiter) beinhalten.

Die Einsatzgebiete der oben beschriebenen Vorrichtung und des oben beschriebenen Verfahrens sind mannigfaltig. Die Plasmabehandlung dient z. B. der Beschichtung, Reinigung, Modifizierung und Ätzung von Werkstücken, zur Behandlung von medizinischen Implantaten, zur Textilbehandlung, zur Sterilisation, zur Lichterzeugung, bevorzugt im Spektralbereich Infrarot bis Ultraviolett, zur Umsetzung von Gasen oder zur Gassynthese, sowie in der Technik zur Abgasreinigung. Dabei wird das zu behandelnde Werkstück oder Gas in Kontakt mit dem Plasma oder der Mikrowellenstrahlung gebracht. Die Geometrie der zu behandelnden Werkstücke reicht von flachen Substraten, Fasern und Bahnen bis zu Formteilen von beliebiger Gestalt.

Durch die Erhöhung der Plasmadichte und der Plasmaleistung sind dabei höhere Prozessgeschwindigkeiten als in Vorrichtungen und Verfahren des Standes der Technik möglich.

## Patentansprüche

1. Vorrichtung zur Erzeugung von Mikrowellenplasmen, welche mindestens eine Mikrowelleneinspeisung aufweist, die von einem äußeren dielektrischen Rohr (3) umgeben ist, wobei
die Mikrowelleneinspeisung zusätzlich von mindestens einem inneren dielektrischen Rohr (10) umgeben ist, das innerhalb des äußeren dielektrischen Rohrs (3) verläuft, wodurch ein Raum gebildet wird, der zur Aufnahme und Durchleitung eines Fluids geeignet ist , **dadurch gekennzeichnet dass** beide dielektrische Rohre (3, 10) an ihren Stirnseiten mit Wänden (5, 6) verbunden sind und jede der Wände (5, 6) mindestens einen Durchlass (8, 9) für das Fluid aufweist.

2. Vorrichtung nach Anspruch 1, **dadurch gekennzeichnet, dass** sich in dem Bereich, den die Stirnseite des inneren dielektrischen Rohres abdeckt, keine Durchlässe befinden.

3. Vorrichtung nach einem der vorhergehenden Ansprüche, **dadurch gekennzeichnet, dass** das äußere dielektrische Rohr zumindest in einem Teilbereich der Mantelfläche oder in dem Bereich der gesamten Mantelfläche porös oder gasdurchlässig ist.

4. Vorrichtung nach einem der vorhergehenden Ansprüche, **dadurch gekennzeichnet, dass** das innere dielektrische Rohr (10) von einem mittleren dielektrischen Rohr (11) umgeben ist, das innerhalb des äußeren dielektrischen Rohrs (3) verläuft.

5. Vorrichtung nach einem der vorhergehenden Ansprüche, **dadurch gekennzeichnet, dass** das äußere dielektrische Rohr (3) teilweise mit einer Metallummantelung (12) umgeben ist.

6. Vorrichtung nach einem der vorhergehenden Ansprüche, **dadurch gekennzeichnet, dass** die Metallummantelung (12) einen Bereich der Mantelfläche des äußeren dielektrischen Rohres (3) frei lässt, der vorzugsweise über die gesamte Länge des dielektrischen Rohres (3) reicht.

7. Vorrichtung nach einem der vorhergehenden Ansprüche, **dadurch gekennzeichnet, dass** die Mikrowelleneinspeisung eine Mikrowellenantenne oder ein Hohlraumresonator mit Koppelstellen, vorzugsweise ein Koaxialresonator, ist und die Mikrowelleneinspeisung über Mikrowellenzuleitungen, vorzugsweise Hohlleiter oder Koaxialleiter, mit einem Mikrowellengenerator, vorzugsweise einem Klystron oder Magnetron, verbunden ist.

8. Verfahren zur Erzeugung von Mikrowellenplasmen in einer Vorrichtung, die mindestens eine Mikrowelleneinspeisung aufweist, welche von einem inneren dielektrischen Rohr (10) umgeben ist, das wiederum von einem äußeren dielektrischen Rohr (3) umgeben ist, wobei ein Fluid durch den Raum zwischen dem inneren dielektrischen Rohr (10) und dem äußeren dielektrischen Rohr (3) geleitet wird, **dadurch gekennzeichnet, dass** beide dielektrische Rohre (3, 10) an ihren Stirnseiten mit Wänden (5, 6) verbunden sind, wobei die Wände Durchlässe (8, 9) aufweisen und dass das Fluid durch die Durchlässe (8, 9) geleitet wird.

9. Verfahren nach Anspruch 8, **dadurch gekennzeichnet, dass** das Fluid eine Flüssigkeit oder ein Gas ist oder enthält und das Fluid vorzugsweise einen geringen dielektrischen Verlustfaktor tan δ im Bereich 10⁻² bis 10⁻⁷ aufweist.

10. Verfahren nach Anspruch 9, **dadurch gekennzeichnet, dass** das äußere dielektrische Rohr (3) aus einem porösen oder gasdurchlässigen Material besteht und dass das Gas, welches durch den Raum zwischen dem inneren dielektrischen Rohr (10) und dem äußeren dielektrischen Rohr (3) geleitet wird, durch das äußere dielektrische Rohr (3) einem Plasmaprozess zugeführt wird.

11. Verfahren nach Anspruch 10, **dadurch gekennzeichnet, dass** dem Plasmaprozess mindestens ein Prozessgas oder mindestens ein Abgas zugeführt wird.

12. Verfahren nach einem der Ansprüche 8 bis 11, **dadurch gekennzeichnet, dass** der Gasdruck in dem Raum zwischen dem inneren dielektrischen Rohr (10) und dem äußeren dielektrischen Rohr (3) größer als der Atmosphärendruck oder gleich dem Atmosphärendruck ist.

13. Verfahren nach einem der Ansprüche 8 bis 11, **dadurch gekennzeichnet, dass** der Gasdruck in dem Raum zwischen dem inneren dielektrischen Rohr (10) und dem äußeren dielektrischen Rohr (3) kleiner als der Atmosphärendruck ist.

14. Verfahren nach einem der Ansprüche 8 bis 13, **dadurch gekennzeichnet, dass** das innere dielektrische Rohr (10) von einem mittleren dielektrischen Rohr (11) umgeben ist, das innerhalb des äußeren dielektrischen Rohrs (3) verläuft, und der Raum zwischen dem äußeren dielektrischen Rohr (3) und dem mittleren dielektrischen Rohr (11) von einem Gas durchströmt wird, und der Raum zwischen dem inneren dielektrischen Rohr (10) und dem mittleren dielektrischen Rohr (11) von einem Fluid durchströmt wird.

15. Verwendung einer Vorrichtung nach einem der Ansprüche 1 bis 7 zur Erzeugung eines Plasmas zur Beschichtung, Reinigung, Modifizierung und Ätzung von Werkstücken, zur Behandlung von medizinischen Implantaten, zur Textilbehandlung, zur Sterilisation, zur Lichterzeugung, bevorzugt im Spektralbereich Infrarot bis Ultraviolett, zur Umsetzung von Gasen oder zur Gassynthese sowie in der Technik zur Abgasreinigung.

## Claims

1. Device for generating microwave plasmas, comprising at least one microwave feed that is surrounded by an outer dielectric tube (3), wherein said microwave feed is surrounded, in addition, by at least one inner dielectric tube (10) that extends inside the outer dielectric tube (3) whereby a space is formed that is suitable for receiving and conducting a fluid, **characterised in that** both dielectric tubes (3, 10) are connected at their end faces with walls (5, 6), and that each of the walls (5, 6) has at least one passage (8, 9) for the fluid.

2. Device according to claim 1, **characterised in that** there are no passages in the region that is covered by the end face of the inner dielectric tube.

3. Device according to any one of the preceding claims, **characterised in that** the outer dielectric tube is porous or gas-permeable in at least a portion of the lateral surface or in the region of the entire lateral surface.

4. Device according to any one of the preceding claims, **characterised in that** the inner dielectric tube (10) is surrounded by a middle dielectric tube (11) that extends inside the outer dielectric tube (3).

5. Device according to any one of the preceding claims, **characterised in that** the outer dielectric tube (3) is partially surrounded by a metal jacket (12).

6. Device according to any one of the preceding claims, **characterised in that** the metal jacket (12) leaves free a region of the lateral surface of the outer dielectric tube (3), which region preferably extends over the entire length of the dielectric tube (3).

7. Device according to any one of the preceding claims, **characterised in that** the microwave feed is a microwave antenna or a cavity resonator with coupling points, preferably a coaxial resonator, and **in that** the microwave feed is connected, via microwave feed lines, preferably hollow waveguides or coaxial conductors, with a microwave generator, preferably a klystron or magnetron.

8. Method for generating microwave plasmas in a device comprising at least one microwave feed that is surrounded by an inner dielectric tube (10), which, in turn, is surrounded by an outer dielectric tube (3), wherein a fluid is conducted through the space between the inner dielectric tube (10) and the outer dielectric tube (3), **characterised in that** both dielectric tubes (3, 10) are connected at their end faces with walls (5, 6), said walls having passages (8, 9), and that said fluid is conducted through the passages (8, 9).

9. Method according to claim 8, **characterised in that** the fluid is, or contains, a liquid or a gas and that the fluid has a low dielectric loss factor tan δ in the range of from 10⁻² to 10⁻⁷.

10. Method according to claim 9, **characterised in that** the outer dielectric tube (3) consists of a porous or gas-permeable material, and that the gas, which is passed through the space between the inner dielectric tube (10) and the outer dielectric tube (3), is fed, through the outer dielectric tube (3), to a plasma process.

11. Method according to claim 10, **characterised in that** at least one process gas or at least one waste gas is supplied to the plasma process.

12. Method according to any one of claims 8 to 11, **characterised in that** the gas pressure in the space between the inner dielectric tube (10) and the outer dielectric tube (3) is higher than the atmospheric pressure or is equal to the atmospheric pressure.

13. Method according to any one of claims 8 to 11, **characterised in that** the gas pressure in the space between the inner dielectric tube (10) and the outer dielectric tube (3) is lower than the atmospheric pressure.

14. Method according to any one of claims 8 to 13, **characterised in that** the inner dielectric tube (10) is surrounded by a middle dielectric tube (11) which extends inside the outer dielectric tube (3), and that a gas passes through the space between the outer dielectric tube (3) and the middle dielectric tube (11), and that a fluid passes through the space between the inner dielectric tube (10) and the middle dielectric tube (11).

15. Use of a device according to any one of claims 1 to 7 for generating a plasma for coating, cleaning, modifying and etching workpieces, for treating medical implants, for treating textiles, for sterilisation, for light generation, preferably in the infrared to ultraviolet spectral region, for converting gases or for gas synthesis, as well as in waste gas purification technology.

## Revendications

1. Dispositif de production de plasmas micro-ondes, comportant au moins une alimentation micro-ondes qui est entourée d'un tube diélectrique extérieur (3),
l'alimentation micro-ondes étant entourée en outre d'un tube diélectrique intérieur (10) qui s'étend à l'intérieur du tube diélectrique extérieur (3), créant ainsi un espace apte à recevoir et à faire passer un fluide, **caractérisé en ce que** les deux tubes diélectriques (3, 10) sont reliés sur leurs faces à des parois (5, 6) et **en ce que** chacune des parois (5, 6) présente au moins un passage (8, 9) pour le fluide.

2. Dispositif selon la revendication 1, **caractérisé en ce que** la zone que recouvre la face du tube diélectrique intérieur est dépourvue de passages.

3. Dispositif selon l'une des revendications précédentes, **caractérisé en ce que** le tube diélectrique extérieur est poreux ou perméable au gaz au moins dans une zone partielle de la surface d'enveloppe ou dans la zone de toute la surface d'enveloppe.

4. Dispositif selon l'une des revendications précédentes, **caractérisé en ce que** le tube diélectrique intérieur (10) est entouré d'un tube diélectrique central (11) qui s'étend à l'intérieur du tube diélectrique extérieur (3).

5. Dispositif selon l'une des revendications précédentes, **caractérisé en ce que** le tube diélectrique extérieur (3) est entouré partiellement d'une gaine métallique (12).

6. Dispositif selon l'une des revendications précédentes, **caractérisé en ce que** la gaine métallique (12) laisse découverte une zone de la surface d'enveloppe du tube diélectrique extérieur (3), qui s'étend de préférence sur toute la longueur du tube diélectrique (3).

7. Dispositif selon l'une des revendications précédentes, **caractérisé en ce que** l'alimentation micro-ondes est une antenne micro-ondes ou une cavité résonante dotée de points de couplage, de préférence un résonateur coaxial, et **en ce que** l'alimentation micro-ondes est reliée à un générateur de micro-ondes, de préférence un klystron ou magnétron, par l'intermédiaire de lignes d'alimentation micro-ondes, de préférence de guides d'ondes ou de conducteurs coaxiaux.

8. Procédé de production de plasmas micro-ondes dans un dispositif comportant au moins une alimentation micro-ondes laquelle est entourée d'un tube diélectrique intérieur (10) qui, de son côté, est entouré d'un tube diélectrique extérieur (3), un fluide étant conduit à travers l'espace entre le tube diélectrique intérieur (10) et le tube diélectrique extérieur (3), **caractérisé en ce que** les deux tubes diélectriques (3, 10) sont reliés sur leur faces à des parois (5, 6), lesdites parois présentant des passages (8, 9), et **en ce que** le fluide est conduit à travers les passages (8, 9).

9. Procédé selon la revendication 8, **caractérisé en ce que** le fluide est, ou contient, un liquide ou un gaz, et **en ce que** le fluide présente de préférence un faible facteur de perte diélectrique tan δ, compris entre 10⁻² et 10⁻⁷.

10. Procédé selon la revendication 9, **caractérisé en ce que** le tube diélectrique extérieur (3) est composé d'un matériau poreux ou perméable au gaz, et **en ce que** le gaz, conduit à travers l'espace entre le tube diélectrique intérieur (10) et le tube diélectrique extérieur (3), est amené à un processus plasma à travers le tube diélectrique extérieur (3).

11. Procédé selon la revendication 10, **caractérisé en ce que** le processus plasma est alimenté avec au moins un gaz de processus ou au moins un gaz d'échappement.

12. Procédé selon l'une des revendications 8 à 11, **caractérisé en ce que** la pression de gaz dans l'espace entre le tube diélectrique intérieur (10) et le tube diélectrique extérieur (3) est supérieure à la pression atmosphérique ou égale à la pression atmosphérique.

13. Procédé selon l'une des revendications 8 à 11, **caractérisé en ce que** la pression de gaz dans l'espace entre le tube diélectrique intérieur (10) et le tube diélectrique extérieur (3) est inférieure à la pression atmosphérique.

14. Procédé selon l'une des revendications 8 à 13, **caractérisé en ce que** le tube diélectrique intérieur (10) est entouré d'un tube diélectrique central (11) qui s'étend à l'intérieur du tube diélectrique extérieur (3), et **en ce que** l'espace entre le tube diélectrique extérieur (3) et le tube diélectrique central (11) est parcouru par un gaz, et **en ce que** l'espace entre le tube diélectrique intérieur (10) et le tube diélectrique central (11) est parcouru par un fluide.

15. Utilisation d'un dispositif selon l'une des revendications 1 à 7 pour la production d'un plasma destiné au revêtement, au nettoyage, à la modification et au décapage de pièces, au traitement d'implants médicaux, au traitement de textiles, à la stérilisation, à la production de lumière, de préférence dans le domaine spectral infrarouge à ultraviolet, à la transformation de gaz ou à la synthèse de gaz, ainsi qu'en technique à l'épuration des gaz d'échappement.
